# EUROPÄISCHE PATENTANMELDUNG

(11) **EP 4 123 698 A1**
(43) Veröffentlichungstag der Anmeldung: **25.01.2023**
(21) Anmeldenummer: 21186450.9
(22) Anmeldetag: 19.07.2021
(51) Int. Cl.: H01L 23/367, H01L 23/46, H05K 7/20

(54) **HALBLEITERANORDNUNG UND STROMRICHTER MIT GLEICHMÄSSIGER KÜHLUNG**

(71) Anmelder: Siemens Aktiengesellschaft, 80333 München (DE)
(72) Erfinder: Ivanov, Radoslav, 94060 Pocking (DE)

(57) **Zusammenfassung**

Die Erfindung betrifft eine Halbleiteranordnung (1) mit einem ersten Halbleiter (11) und einem zweiten Halbleiter (12), einem Kühlkörper (2) zum Übertragen von Verlustwärme des ersten Halbleiters (11) und des zweiten Halbleiters (12) an ein Kühlmedium (3), wobei der erste Halbleiter (11) und der zweite Halbleiter (12) derart an dem Kühlkörper (2) angeordnet sind, dass von dem zweiten Halbleiter (12) Verlustwärme an das von dem ersten Halbleiter (11) vorerwärmte Kühlmedium (3) übertragbar ist. Zur Verbesserung der Halbleiteranordnung (1) wird vorgeschlagen, dass ein erster thermischer Widerstand (Rₜₕ₁) für den Wärmeübergang von dem ersten Halbleiter (11) zu dem Kühlmedium (3) größer ist als ein zweiter thermischer Widerstand (Rₜₕ₂) für den Wärmeübergang von dem zweiten Halbleiter (12) zu dem Kühlmedium (3). Ferner betrifft die Erfindung einen Stromrichter (30) mit mindestens einer derartigen Halbleiteranordnung (1). Die Erfindung betrifft weiter ein Verfahren zum Betreiben einer derartigen Halbleiteranordnung (1) oder eines derartigen Stromrichters (30), wobei in Abhängigkeit von der Temperatur des Kühlmediums (3) und/oder eines der Halbleiter (11,12,13) die Fließgeschwindigkeit des Kühlmediums (3) verändert wird.

## Beschreibung

Die Erfindung betrifft eine Halbleiteranordnung aufweisend einen ersten Halbleiter und einen zweiten Halbleiter sowie einen Kühlkörper zum Übertragen von Verlustwärme des ersten Halbleiters und des zweiten Halbleiters an ein Kühlmedium, wobei der erste Halbleiter und der zweite Halbleiter derart angeordnet sind, dass von dem zweiten Halbleiter Verlustwärme an das von dem ersten Halbleiter vorerwärmte Kühlmedium übertragbar ist. Ferner betrifft die Erfindung einen Stromrichter mit einer derartigen Halbleiteranordnung. Die Erfindung betrifft weiter ein Verfahren zum Betreiben einer derartigen Halbleiteranordnung oder eines derartigen Stromrichters.

Halbleiter, insbesondere Leistungshalbleiter, erzeugen bei ihrem Betrieb Verluste. Diese entstehen aufgrund eines Spannungsabfalls im Halbleiter zu Durchlassverlusten oder beim Schalten, insbesondere wenn die Halbleiter pulsweitenmoduliert betrieben werden, als Schaltverluste. Diese Verluste werden in Form von Wärme an die Umgebung abgeführt, um eine Überhitzung der Halbleiter zu verhindern. Dazu werden die Halbleiter mittels eines Kühlkörpers durch ein Kühlmedium, wie beispielsweise Luft oder eine Flüssigkeit gekühlt. Das Kühlmedium nimmt dabei die Verluste auf und erwärmt sich.

Dabei werden häufig mehrere Halbleiter an dem Kühlkörper angeordnet und, meistens mit einer Schraub- oder Steckverbindung, daran befestigt. Das Kühlmedium strömt entlang des Kühlkörpers oder durch einen Kühlkanal oder mehrere Kühlkanäle des Kühlkörpers. Dabei fließt das Kühlmedium, unabhängig davon, ob gasförmig oder flüssig, entlang einer Oberfläche des Kühlkörpers von dem Bereich zur Kühlung eines ersten Halbleiters zu dem Bereich zur Kühlung eines zweiten Halbleiters. Dabei erwärmt sich das Kühlmedium von Halbleiter zu Halbleiter stärker. Man spricht in diesem Zusammenhang von einer thermischen Reihenschaltung der Halbleiter, da die Halbleiter nacheinander, sozusagen in einer Reihe, ihre Wärme an das Kühlmedium übertragen. Die Erwärmung des Kühlmediums durch die thermisch vorgelagerten Halbleiter wird als Vorerwärmung bezeichnet. Bei den thermisch vorgelagerten Halbleitern handelt es sich um Halbleiter, die das Kühlmedium bereits erwärmt haben, bevor es den Bereich für die Kühlung des betreffenden Halbleiters erreicht hat und für die Kühlung des betreffenden Halbleiters genutzt werden kann.

Die höhere Temperatur des Kühlmediums führt dazu, dass es mit steigender Temperatur immer schlechter Wärme aufnehmen kann. Dadurch ist die Kühlung im Bereich der thermisch nachgelagerten Halbleiter deutlich schlechter. Dies führt zu einer deutlich schlechteren Lebensdauer dieser Halbleiter.

Um dies zu vermeiden werden die Halbleiter überdimensioniert. Dies verursacht jedoch hohe Kosten, da gerade die thermisch vorgelagerten Halbleiter nicht gut ausgenutzt sind.

Ebenso ist es möglich, die Halbleiter nicht thermisch in Reihe, sondern thermisch parallel anzuordnen. Dabei teilt sich der Kühlmittelstrom auf und durchfließt den Kühlkörper so, dass von jedem Teilfluss nur einer der Halbleiter gekühlt wird. Durch das Aufteilen ist das Kühlsystem sehr komplex. Dazu muss sichergestellt werden, dass die aufgeteilten Kühlmittelflüsse sich gleich verhalten. Die Regelung der Kühlmittelflüsse ist schwierig und auch hier muss durch geeignete und aufwändige Maßnahmen sichergestellt werden, dass der gleiche, zumindest ein minimaler Kühlmittelfluss für die einzelnen Halbleiter zustande kommt.

Alternativ ist es möglich, gerade bei einer Flüssigkeitskühlung eine sogenannte Schneckenstruktur im Kühlkörper vorzusehen, bei dem der Kühlkanal schneckenförmig ausgebildet ist. Dabei nimmt das Kühlmedium zunächst nur einen Teil der Wärme eines ersten Halbleiters auf, bevor es zu dem Bereich für die Kühlung des zweiten Halbleiters weiterfließt. Danach fließt es wieder zurück und nimmt sozusagen nacheinander Teile der Wärme vom ersten und vom zweiten, sowie ggf. noch von weiteren Halbleitern auf. Dadurch lässt sich ebenfalls die Kühlung von mehreren Halbleitern vergleichmäßigen. Allerdings ist solch eine Struktur teuer in der Herstellung und somit sind solche Kühlkörper teuer und müssen meist auf den jeweiligen Einsatz angepasst werden.

Der Erfindung liegt die Aufgabe zugrunde, die Kühlung einer Halbleiteranordnung mit mehreren Halbleitern zu verbessern.

Diese Aufgabe wird durch Halbleiteranordnung aufweisend einen ersten Halbleiter und einen zweiten Halbleiter, sowie einen Kühlkörper zum Übertragen von Verlustwärme des ersten Halbleiters und des zweiten Halbleiters an ein Kühlmedium gelöst, wobei der erste Halbleiter und der zweite Halbleiter derart an dem Kühlkörper angeordnet sind, dass von dem zweiten Halbleiter Verlustwärme an das von dem ersten Halbleiter vorerwärmte Kühlmedium übertragbar ist, wobei ein erster thermischer Widerstand für den Wärmeübergang von dem ersten Halbleiter zu dem Kühlmedium größer ist als ein zweiter thermischer Widerstand für den Wärmeübergang von dem zweiten Halbleiter zu dem Kühlmedium. Ferner wird diese Aufgabe durch einen Stromrichter mit mindestens einer derartigen Halbleiteranordnung gelöst. Diese Aufgabe wird weiter durch ein Verfahren zum Betreiben einer derartigen Halbleiteranordnung oder eines derartigen Stromrichters gelöst, wobei in Abhängigkeit von der Temperatur des Kühlmediums und/oder eines der Halbleiter die Fließgeschwindigkeit des Kühlmediums verändert wird.

Weitere vorteilhafte Ausgestaltungen der Erfindung sind in den abhängigen Ansprüchen angegeben.

Der Erfindung liegt unter anderem die Erkenntnis zugrunde, dass sich die Kühlung der einzelnen Halbleiter der Halbleiteranordnung dadurch verbessern lässt, indem die thermischen Widerstände, die den Übergang der Wärme vom Halbleiter zum Kühlmedium beschreiben, unterschiedlich ausgebildet werden. Somit wird am Kühlkörper in Bereich der Halbleiter jeweils eine eigene Kühlstruktur vorgesehen. Diese Kühlstrukturen unterscheiden sich derart, dass diese einen unterschiedlichen thermischen Widertand vom Halbleiter zum Kühlmedium ergeben. Je stärker das Kühlmedium bereits vorerwärmt ist, desto geringer wird der thermische Widerstand für den Übergang der Wärme des entsprechenden Halbleiters ausgeführt. Daher weist die Halbleiteranordnung im Bereich des ersten Halbleiters einen höheren thermischen Widerstand auf als im Bereich des zweiten Halbleiters. Durch den geringeren thermischen Widerstand kann das schlechtere Aufnahmeverhalten des Kühlmediums aufgrund der erhöhten Temperatur kompensiert werden. Der Vorteil dieser Anordnung besteht darin, dass die Auswirkung der Vorerwärmung des Kühlmediums durch einen verbesserten thermischen Widerstand kompensiert wird. In der Folge ergeben sich an den Halbleitern gleiche oder zumindest nahezu gleiche thermische Bedingungen. Mit anderen Worten weisen die Halbleiter, insbesondere an den Stellen, die für den ordnungsgemäßen Betrieb und einer hohen Lebensdauer von Bedeutung sind, gleiche oder zumindest nahezu gleiche Temperaturen auf.

Die Variierung des thermischen Widerstands kann auf unterschiedliche Weise vorgenommen werden. Man kann beispielsweise in einem Bereich von höheren thermischen Widerständen kleinere und/oder kurzer Kühlrippen, sogenannte Fins oder Pins anordnen. Alternativ oder zusätzlich kann auch die Anzahl der Fins oder Pins reduziert werden. Des Weiteren ist es möglich, als Alternative oder ergänzend zu den anderen Möglichkeiten, das Material des Kühlkörpers in den Bereichen der einzelnen Halbleiter zu variieren, so dass sich unterschiedliche thermische Widerstände ergeben. Eine weitere Möglichkeit, alternativ oder ergänzend zu den anderen Möglichkeiten, die Dicke des Kühlkörpers zwischen dem Halbleiter und dem Kühlmedium zu variieren.

Beispielsweise kann zur Erzielung des ersten thermischen Widerstands zumindest in Teilen des für den Wärmeübergang relevanten Bereichs des ersten Halbleiters am Kühlkörper und/oder im Kühlkanal kleinere Pins und/oder Fins, insbesondere kürzere und/oder schlankere Pins und/oder Fins, angeordnet werden als im Vergleich zum entsprechenden Bereich des zweiten Halbleiters. Alternativ oder zusätzlich ist es möglich, dass der Kühlkörper zur Erzielung des ersten thermischen Widerstands im Bereich des ersten Halbleiters zumindest in Teilen des für den Wärmeübergang relevanten Bereichs des ersten Halbleiters eine kleinere Anzahl von Pins und/oder Fins aufweist als im entsprechenden Bereich des zweiten Halbleiters.

Da das wärmste Element, insbesondere der wärmste Halbleiter bestimmend ist für die elektrische und thermische Auslegung der Halbleiteranordnung, findet ein Derating statt, wenn der Effekt der Vorerwärmung nicht kompensiert wird. Das liegt daran, dass der Halbleiter mit der höchsten Temperatur, die sich ohne Kompensation aus der größten Vorerwärmung ergibt, für die Berechnung herangezogen wird. Die übrigen Halbleiter werden dann nicht in ihrer vollen Leistungsfähigkeit ausgenutzt. Durch die Kompensation über unterschiedlichen Vorerwärmung durch die unterschiedlichen thermischen Widerstände können alle Halbleiter mit ihrer gesamten Leistungsfähigkeit, zumindest mit nahezu der gesamten Leistungsfähigkeit werden. Somit findet ein Derating, also eine verminderte Ausnutzung der Leistungsfähigkeit, nicht oder nur in einem geringen Maße statt. Die Ausnutzung aller Halbleiter der Halbleiteranordnung wird dadurch verbessert.

Auf eine aufwändige Schneckenstruktur zur Führung des Kühlmediums kann bei Anwendung der vorgeschlagenen Halbleiteranordnung verzichtet werden. Der Kühlkanal kann dabei vorzugsweise gradlinig ausgebildet sein. Diese Ausführungen, sowohl die Gradlinige Ausführung als auch der Verzicht auf eine Schneckenstruktur an sich, wiederum senken aufgrund des geringeren Druckabfalls die Anforderungen an die Leistungsfähigkeit eines Lüfters oder einer Kühlmittelpumpe. Das Kühlsystem kann somit auch besonders energieschonend und energiesparend betrieben werden. Darüber hinaus ist es in seiner Struktur als auch mit den Komponenten zur Bewegung des Kühlmittels kostengünstiger herstellbar.

Insgesamt ergibt sich der Vorteil, dass es mit dieser Anordnung möglich ist, den Kühlkörper deutlich günstiger herzustellen und gleichzeitig eine gleichmäßige Belastung der darauf angeordneten Halbleiter sicherzustellen. Durch die gleichmäßige Belastung ergibt sich zudem eine teilweise deutliche Steigerung der Lebensdauer und auch eine Angleichung der Lebensdauern der einzelnen Halbleiter. Durch die Angleichung der Temperaturen kann auf ein Derating verzichtet werden. Die Halbleiter der Anordnung können besser ausgenutzt werden. Dies führt zu einer Steigerung der Leistungsfähigkeit, insbesondere wenn eine Vielzahl von Halbleitern, beispielsweise sechs Halbleiter, in der Halbleiteranordnung angeordnet sind.

Eine Halbleiteranordnung mit genau zwei Halbleitern lässt sich besonders vorteilhaft für die Phase eines Stromrichters verwenden. Dabei wird der Anschluss dieser Phase entweder mit dem ersten Zwischenkreispotential, beispielsweise einem Pluspotential oder einem Plusanschluss, oder mit dem zweiten Zwischenkreispotential, beispielsweise einem Minuspotential oder einem Minusanschluss, elektrisch verbunden. Eine andere vorteilhafte Anwendung eine Halbleiteranordnung mit genau zwei Halbleitern besteht darin, dass diese Halbleiter elektrisch parallel angeordnet werden und damit einen leistungsfähigeren Schalter bilden.

Da die Belastung mit dem Strom und damit die thermische Belastung beider dieser Halbleiter in den genannten Anwendungen über eine Periode der Wechselspannung nahezu identisch ist, bietet sich die vorgeschlagene Anordnung gerade für eine Halbleiteranordnung mit zwei Halbleitern in besonders vorteilhafter Form an. In diesem Fall ist die Verlustleistung nahezu identisch, zumindest über eine Periode des wechselspannungsseitigen Signals. Das Signal kann dabei eine Spannung oder ein Strom an der Stromrichterphase sein. Mit Hilfe der vorgeschlagenen Anordnung können die Temperaturen bei gleicher Verlustleitung gleich gehalten werden, so dass sich auch keine unterschiedliche Alterung der Halbleiter ergibt. Dies führt zu einer hohen Lebensdauer der Halbleiter.

Der Vorteil dieser Anordnung besteht nicht nur darin, dass sich die Temperaturen der Halbleiter annähern, sondern es ergibt sich der bessere thermische Widerstand als weiterer Vorteil, weil die Chiptemperatur der Halbleiter durch die Halbleiteranordnung niedriger ist als die Temperatur eines Hotspots, ohne die Maßnahmen zum Temperaturausgleich wie in der vorgeschlagenen Halbleiteranordnung.

Des Weiteren bietet die Halbleiteranordnung auch die Möglichkeit, einfachere und kostengünstigere Kühlkörper einzusetzen. Auch die Leistungsteile für ein Schrankgerät, wie beispielsweise bei einem Stromrichter werden kostengünstiger.

Um die Temperatur aller Halbleiter zu beeinflussen, die bei der vorgeschlagenen Halbleiteranordnung nahezu gleich sind, hat es sich als vorteilhaft erwiesen, die Fließgeschwindigkeit des Kühlmediums in Abhängigkeit der Temperatur des Kühlmediums oder eines Halbleiters der Halbleiter zu verändern. Da die Temperatur aufgrund der vorgeschlagenen Anordnung der Halbleiteranordnung für die Halbleiter alle nahezu gleich ist, bietet sich an, nur eine der Halbleitertemperaturen für die Regelung oder Steuerung der Fließgeschwindigkeit heranzuziehen. Um dennoch ein Fehlverhalten in der Kühlung zu erkennen, bietet sich darüber hinaus an, auch die Temperatur des Kühlmediums zu messen und zusätzlich oder alternativ für die Steuerung der Fließgeschwindigkeit des Kühlmediums zu verwenden.

Besonders vorteilhaft ist die Anwendung einer derartigen Halbleiteranordnung für einen Stromrichter. Stromrichter weisen abhängig von der Anzahl ihrer Phasenanschlüsse eine Vielzahl von Halbleitern auf. Ziel ist es in einem Stromrichter, die Belastung der Halbleiter und damit auch die Lebensdauer der Halbleiter gleich zu gestalten. Darüber hinaus ist es für eine hohe Leistungsfähigkeit des Stromrichters erstrebenswert, dass die Halbleiter des Stromrichters möglichst gut in ihrer Leistungsfähigkeit ausgenutzt werden. Mit der vorgeschlagenen Halbleiteranordnung ist ein Stromrichter mit hoher Leistungsfähigkeit und Lebensdauer realisierbar und herstellbar.

Bei einer vorteilhaften Ausgestaltung der Erfindung weist die Halbleiteranordnung mindestens einen weiteren Halbleiter auf, wobei der weitere Halbleiter derart angeordnet ist, dass von dem weiteren Halbleiter Verlustwärme an das von dem ersten und dem zweiten Halbleiter vorerwärmte Kühlmedium übertragbar ist, wobei ein dritter thermischer Widerstand für den Wärmeübergang von dem weiteren Halbleiter zu dem Kühlmedium jeweils kleiner ist als der erste thermische Widerstand und als der zweite thermische Widerstand. Oftmals ist die Halbleiteranordnung mit genau drei Halbleitern als Modul verfügbar. Dabei wird der thermische gesehen hinterste Halbleiter, also der weitere Halbleiter, mit dem Kühlmedium gekühlt, das bereits die Wärme von zwei thermisch davor liegenden Halbleitern, dem ersten Halbleiter und dem zweiten Halbleiter, aufgenommen hat und somit eine höhere Temperatur aufweist. Dies wird auch als thermische Reihenschaltung beschreiben. In diesem Falle von drei Halbleitern ist es eine thermische Reihenschaltung von drei Elementen. Diese bewirkt, dass das letzte Element der Reihenschaltung, also der weitere oder dritte Halbleiter, eine deutliche Erhöhung des Kühlmediums erfährt. Um dieses auszugleichen und eine thermische Überlastung oder ein Derating zu verhindern, wird der dritte thermische Widerstand für den Wärmeübergang des weiteren Halbleiters, insbesondere eines dritten Halbleiters, zum Kühlmedium kleiner realisiert als die jeweiligen beiden thermischen Widerstände des ersten und des zweiten Halbleiters. Damit kann eine Angleichung der Halbleitertemperaturen erreicht, eine Überlastung bzw. ein Derating der Halbleiteranordnung vermieden werden. Alle Halbleiter in dieser Anordnung können dann hoch ausgenutzt werden.

Bei einer weiteren vorteilhaften Ausgestaltung der Erfindung weist die Halbleiteranordnung eine Vielzahl von Halbleitern, insbesondere genau sechs Halbleiter, auf, wobei die Halbleiter thermisch in Reihe angeordnet sind, wobei der thermische Widerstand zwischen einem der Halbleiter und dem Kühlmedium in Positionen mit zunehmender Vorerwärmung durch den bzw. die thermisch vorgelagerten Halbleiter sinkt. Mit steigender Anzahl von Halbleitern verstärkt sich der Effekt der Vorerwärmung immer mehr. In Richtung der steigenden Vorerwärmung des Kühlmediums werden die thermischen Widerstände im Bereich der jeweiligen Halbleiter immer weiter reduziert. Dabei können die thermischen Widerstände derart bemessen sein, dass bei nominaler Verlustleistung der Halbleiter alle Halbleiter der Vielzahl der Halbleiter die gleiche Temperatur annehmen.

Ohne die vorgeschlagene Maßnahme würden die Temperaturen der einzelnen Halbleiter deutlich auseinanderlaufen. Für einen dreiphasigen Stromrichter werden für die Umwandlung zwischen Gleichstrom und Wechselstrom sechs Halbleiter benötigt. Daher hat es sich als sinnvoll erwiesen, eine Halbleiteranordnung mit genau sechs Halbleitern als Modul zu realisieren, da sich mit diesem Modul die Funktion eines Stromrichters umsetzen lässt. Dieses Modul erfordert dann auch nur eine Regelung. Im Allgemeinen kann auch davon ausgegangen werden, dass die einzelnen Halbleiter dieser Halbleiteranordnung gleich oder zumindest in etwas gleich belastet werden. Da oftmals Motoren durch den Stromrichter elektrisch versorgt werden und diese symmetrisch bezüglich der Phasen aufgebaut sind, ergibt sich auch eine symmetrische, also gleiche, Belastung in den drei Phasen des Stromrichters, die jeweils durch zwei Halbleiter gebildet werden. Somit erfahren die Halbleiter aufgrund der entstehenden elektrischen Verluste nahezu die gleiche Belastung. Um auf ein Derating zu verzichten und eine unterschiedlich hohe thermische Belastung zu vermeiden, die zu einem hohen Lebensdauerverbrauchs einzelner Bauelemente führen kann, hat es sich gerade bei dieser Anordnung als vorteilhaft erwiesen, unterschiedliche thermische Widerstände für die jeweiligen Halbleiter vorzusehen. Damit kann ein Halbleiteranordnung realisiert werden, mit der ein 3phasiger Stromrichter herstellbar ist. Durch die vorgeschlagene Anordnung weist dieser Stromrichter eine besonders hohe Lebensdauer auf. Aufgrund des Wegfalls des Deratings bzw. eines nur geringen Deratings wird der Stromrichter und insbesondere die Halbleiter des Stromrichters besonders gut und schonend ausgenutzt.

Bei einer weiteren vorteilhaften Ausgestaltung der Erfindung weisen die Halbleiter eine für den Betrieb zulässige Sperrschichttemperatur von mindestens 150°C auf. Je höher die Temperatur des Halbleiters ist, desto höher ist auch die Vorerwärmung durch thermisch vorgelagerte Halbleiter. Die hohe Sperrschichttemperatur kann aber besonders gut dann ausgenutzt werden, wenn die thermische Belastung der Halbleiter nahezu gleich bleibt. Ansonsten würde ein Derating die Vorteile eine erhöhten Sperrschichttemperatur wieder verschwinden lassen. Mit anderen Worten lässt sich eine hohe zulässige Sperrschichttemperatur besonders vorteilhaft nutzen, wenn durch die vorgeschlagene Anordnung auf ein Derating verzichtet werden kann. Die mit der hohen Sperrschichttemperatur einhergehende höhere Leistungsfähigkeit der Halbleiter kann für die Anordnung insbesondere in einem Stromrichter nahezu vollständig genutzt werden.

Bei einer weiteren vorteilhaften Ausgestaltung der Erfindung weisen die Halbleiter in ihrem thermischen Verhalten eine positive Strom-Temperaturabhängigkeit auf. Eine positive Strom-Temperaturabhängigkeit begünstigt den Effekt, dass die Temperaturen der Halbleiter auseinanderlaufen. Dieser Effekt ist insbesondere bei elektrisch parallel angeordneten Halbleitern beobachtbar und tritt dort auf. Durch die höhere Temperatur ergibt sich eine geringere Durchlassspannung, so dass dieses Element dann deutlich mehr Strom in der Parallelschaltung trägt und sich damit aufgrund der Durchlassverluste noch weiter aufheizt. Das wärmste Element übernimmt dann den höchsten Strom und erwärmt sich weiter. Durch den vorgeschlagenen Aufbau kann diesem Effekt entgegengewirkt werden, da sich die Temperaturen der Halbleiter durch die vorgeschlagene Anordnung angleichen. Wenn ein thermisch nachgelagertes Modul sich durch einen hohen Strom stärker erwärmt, fällt gleichzeitig die Vorerwärmung weg, so dass sich das nachgelagerte Modul nicht weiter erwärmt, sondern tendenziell sich abkühlt. Damit gleichen sich die Temperaturen der Halbleiter, insbesondere der elektrisch parallel angeordneten Halbleiter weiter an. Dadurch wird eine ungleichmäßige Aufteilung des Stroms auf die elektrisch parallel angeordneten Halbleiter zuverlässig vermieden.

Bei einer weiteren vorteilhaften Ausgestaltung der Erfindung weisen die Halbleiter Galliumnitrit oder Siliziumcarbid auf. Diese Art von Halbleitern weisen sowohl eine hohe zulässige Sperrschichttemperatur von mindestens 150°C als auch eine positive Strom-Temperaturabhängigkeit in ihrem thermischen Verhalten auf. Durch die vorgeschlagene Halbleiteranordnung können sowohl die negativen Effekte, die sich wie oben beschrieben aus der hohen Sperrschichttemperatur und der positiven Strom-Temperaturabhängigkeit ergeben, beseitigt werden. Dies führt zu einem geringen Derating der Halbleiter. Mit anderen Worten werden die Halbleiter thermisch derart gut ausgelastet, dass sie noch Auslegungsreserven aufweisen. Diese Auslegungsreserven können für einen Betrieb mit hoher Schaltfrequenz, insbesondere für Schaltfrequenzen über 10kHz oder sogar über 100kHz genutzt werden. Gerade die Halbleiter auf Basis von Galliumnitrit und Siliziumcarbid weisen ein hohes Schaltvermögen auf. Dieses ermöglicht einen Betrieb bei hohen Schaltfrequenzen, insbesondere im Frequenzbereich von 10kHz bis 100kHz. Somit haben die Maßnahmen zur Angleichung der Temperatur der Halbleiter in der vorgeschlagenen Halbleiteranordnung für Halbleiter, Galliumnitrit oder Siliziumcarbid aufweisen, zusätzlich den Vorteil, dass die entstehenden thermischen Reserven aufgrund der Temperaturangleichung für eine höhere Schaltfrequenz genutzt werden können.

Bei einer weiteren vorteilhaften Ausgestaltung der Erfindung sind mindestens zwei der Halbleiter elektrisch parallel angeordnet sind. Bei der Parallelschaltung muss ein besonderes Augenmerk auf die Stromaufteilung gelegt werden. Insbesondere bei Vorliegen eines positiven Strom-Temperaturabhängigkeit kann eine Parallelschaltung der Halbleiter zu einer hohen Fehlverteilung, d.h. ungleichen Verteilung oder Aufteilung der Ströme auf die parallel angeordneten Halbleiter führen. Durch die vorgeschlagene Halbleiteranordnung wird diese Fehlverteilung vermieden und es können nahezu gleiche Ströme durch die parallel angeordneten Halbleiter erzeugt werden. Dies führt zu einem geringen Derating und somit zu einer hohen Ausnutzung und einem hohen Wirkungsgrad der Halbleiter und daraus aufgebauten Komponenten wie beispielsweise einem Stromrichter.

Bei einer weiteren vorteilhaften Ausgestaltung der Erfindung ist der Kühlkörper als flüssigkeitsgekühlter Kühlkörper mit einem Kühlkanal ausgebildet. Bei einem flüssigkeitsgekühlten Kühlkörper, also einem Kühlkörper, bei dem das Kühlmittel ein Fluid, wie beispielsweise Wasser ist, ist die vorgeschlagene Halbleiteranordnung besonders vorteilhaft. Durch den geschlossenen Kühlkreislauf einer Flüssigkeitskühlung ist der Effekt der Vorerwärmung besonders groß. Während bei einer Luftkühlung auch vorerwärmungsfreie Luft, also nicht durch thermisch vorgelagerte Komponenten vorerwärmte Luft, zumindest zu Teilen einem Luftstrom zugeführt werden kann, ist bei einer Flüssigkeitskühlung aufgrund des geschlossenen Systems derartiges Zumischen von vorerwärmungsfreien Fluid für die thermisch nachgelagerten Halbleiter nicht möglich. Eine bereits bekannte Schneckenform oder Mäanderform des Kühlkanals hat sogar noch den Nachteil eines hohen Druckabfalls im Strömungskanal, das eine leistungsfähige Kühlmittelpumpe erfordert. Somit ist die Halbleiteranordnung insbesondere bei der Verwendung eines flüssigen Kühlkörpers vorteilhaft, da neben der Angleichung der Halbleitertemperaturen auch der Druckabfall im Kühlkreislauf reduziert und Pumpen mit geringerer Leistungsfähigkeit eingesetzt werden können. Dadurch wird auch die Flüssigkeitskühlung deutlich wirtschaftlicher im Einsatz.

Bei einer weiteren vorteilhaften Ausgestaltung der Erfindung weist der Kühlkanal zumindest in Teilen des für den Wärmeübergang relevanten Bereichs des ersten Halbleiters eine größere Querschnittsfläche auf im Vergleich zu der Querschnittsfläche im entsprechenden Bereich des zweiten Halbleiters. Das reduziert die Geschwindigkeit in dem Eingangsbereich des Kühlmediums und erhöht damit den thermischen Widerstand. Gleichzeitig wird der Differenzdruck im Bereich des ersten Halbleiters reduziert, so dass sich für den zweiten Halbleiter ein höherer Differenzdruck ergibt. Mit diesem höheren Differenzdruck im Bereich des zweiten Halbleiters wird eine höhere Geschwindigkeit des Kühlmediums erreicht. Durch diese höhere Geschwindigkeit ergibt sich ein besserer Wärmeübergang an das Kühlmedium und somit ein geringerer thermischer Widerstand.

Bei einer weiteren vorteilhaften Ausgestaltung der Erfindung weist der Kühlkörper in einem ersten Bereich des ersten Halbleiters ein erstes Material mit einer geringeren thermischen Leitfähigkeit auf als ein zweites Material im entsprechenden zweiten Bereich des zweiten Halbleiters. Neben einer unterschiedlichen Ausgestaltung von Kühlrippen, Fins und/oder Pins ist es alternativ oder ergänzend möglich, den thermischen Widerstand mit der Wahl des Kühlkörpermaterials zu beeinflussen. Dabei wird zur Verringerung des thermischen Widerstands ein Material mit höherer thermischer Leitfähigkeit gewählt und in dem entsprechenden Bereich des Kühlkörpers angeordnet. Bei Fins und Pins handelt es sich um Kühlrippen. Dabei können in Bereichen mit geringerem thermischem Widerstand auch einfache und billigere Materialien einsetzbar. Nur in Bereichen, in denen ein geringerer thermische Widerstand erforderlich ist, kann ein gut wärmeleitfähiges Material angeordnet werden. Selbst wenn dieses teuer ist, wirkt sich dies aufgrund ihrer beschränkten räumlichen Ausdehnung nur im geringen Maße auf die Halbleiteranordnung, insbesondere auf die Herstellkosten der Halbleiteranordnung, aus. Die Staffelung der thermischen Widerstände über die einzelnen Bereiche der Oberfläche des Kühlkörpers, an der die Halbleiter angeordnet sind, bringt den Vorteil, dass in manchen Bereichen mit hohem thermischem Widerstand ein günstiges Material mit geringer Wärmeleitfähigkeit zum Einsatz kommen kann und in Bereichen mit einem niedrigeren thermischen Widerstand hochwertigere und damit auch teurere Materialien zum Einsatz kommen können. Der gesamte Kühlkörper ist mit den unterschiedlichen Materialien kostengünstig herstellbar und ist durch den gezielten Einsatz hochwertiger Materialien besonders leistungsfähig in der Kühlung. Dies betrifft sowohl die Leistungsfähigkeit in Bezug der Abfuhr der Wärme als auch in der gleichmäßigen Kühlung aller Halbleiter.

Bei einer weiteren vorteilhaften Ausgestaltung der Erfindung weist der Kühlkörper im Bereich des ersten Halbleiters eine größere Materialstärke, insbesondere zwischen dem betreffenden Halbleiter und dem Kühlkanal auf, im Vergleich zum entsprechenden Bereich des zweiten Halbleiters. Der Teil des Kühlkörpers zwischen Halbleiter und Kühlmedium kann dabei beispielsweise in Richtung der weiteren Halbleiter stufenförmig ausgebildet sein oder sich beispielsweise kontinuierlich ändern. Durch das dickere Material im Bereich der weniger vorerwärmten Halbleiter, wie beispielsweise dem ersten Halbleiter, ist in diesem Bereich ein höherer thermischer Widerstand vorhanden. Zudem kann ergänzend, insbesondere bei einer Flüssigkeitskühlung, der Kühlkanal im Bereich des ersten Halbleiters einen kleineren Querschnitt aufweisen als im Bereich des zweiten Kühlkörpers. Dies reduziert ebenfalls die Vorerwärmung des Kühlmediums im Bereich des ersten Halbleiters. Die dickere Struktur im Bereich der Halbleiter mit geringer Vorerwärmung vergrößert zudem auch die mechanische Stabilität des Kühlkörpers. In Verbindung mit unterschiedlichen Materialien in den unterschiedlichen Bereichen der jeweiligen Halbleiter, lassen sich im Bereich der Kühlkörper mit geringer Vorerwärmung Materialien mit einer besonders hohen Festigkeit wählen, um dem gesamten Kühlkörper eine hohe Festigkeit zu geben. Diese Materialien, insbesondere im ersten Bereich des ersten Halbleiters, werden dann in Bezug auf ihre mechanischen Eigenschaften ausgewählt und die thermischen Eigenschaften können hier vernachlässigt werden. Damit ergibt sich ein besonders vorteilhafter synergetischer Effekt zwischen der Dicke des entsprechenden Materials, insbesondere des ersten Materials im ersten Bereich des Kühlkörpers, und den thermischen wie auch mechanischen Eigenschaften des entsprechenden Materials.

Im Folgenden wird die Erfindung anhand der in den Figuren dargestellten Ausführungsbeispiele näher beschrieben und erläutert. Es zeigen:
- FIG 1: eine Halbleiteranordnung mit sechs Halbleitern,
- FIG 2: die thermische Abhängigkeit eines Halbleiters,
- FIG 3: eine bekannte Anordnung und
- FIG 4 bis FIG 8: Ausführungsbeispiele zu Erreichung unterschiedlicher thermischer Widerstände.

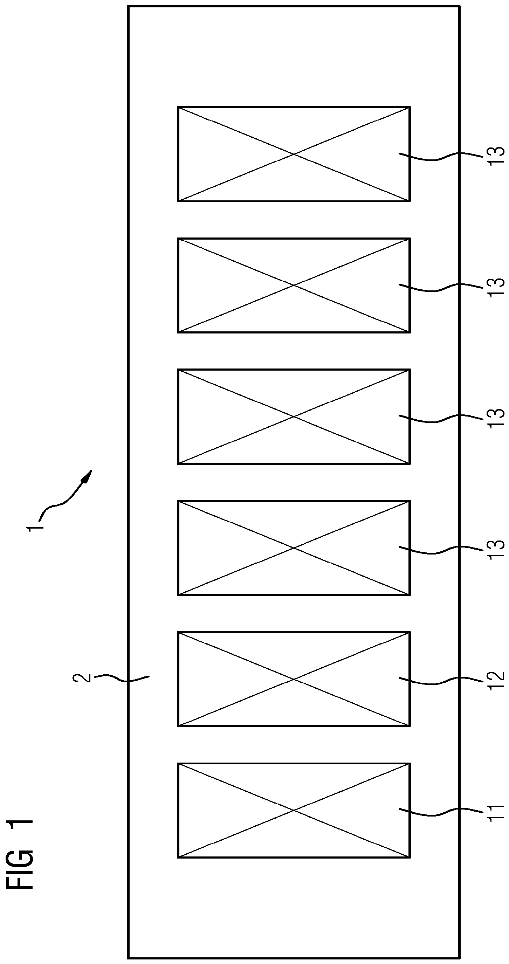

Die FIG 1 zeigt eine Halbleiteranordnung 1, bei der sechs Halbleiter 11, 12, 13 auf einem Kühlkörper 2 angeordnet sind. Dies ist eine typische Anwendung für eine dreiphasige Brückenschaltung. Alternativ können auch mehrere oder alle Halbleiter in einer Parallelschaltung angeordnet sein. Die vorgeschlagene Lösung ist auch für mindestens zwei Halbleiter 11, 12, also einem ersten Halbleiter 11 und einem zweiten Halbleiter 12 anwendbar, sofern der zweite Halbleiter 12 eine Vorerwärmung des ersten Halbleiters 11 erfährt. In diesem Ausführungsbeispiel bedeutet das, dass es eine Bewegung des hier nicht dargestellten Kühlmittels von links nach rechts gibt, so dass die jeweiligen Halbleiter, der zweite Halbleiter und die weiteren Halbleiter 12, 13 jeweils eine Vorerwärmung durch die jeweils links von diesem angeordneten Halbleiter 11, 12, 13 erfahren.

Eine weitere typische Anwendung für eine derartige Anwendung ist ein IGBT-Modul, das sechs Halbleiter aufweist, die thermisch in Reihe angeordnet sind.

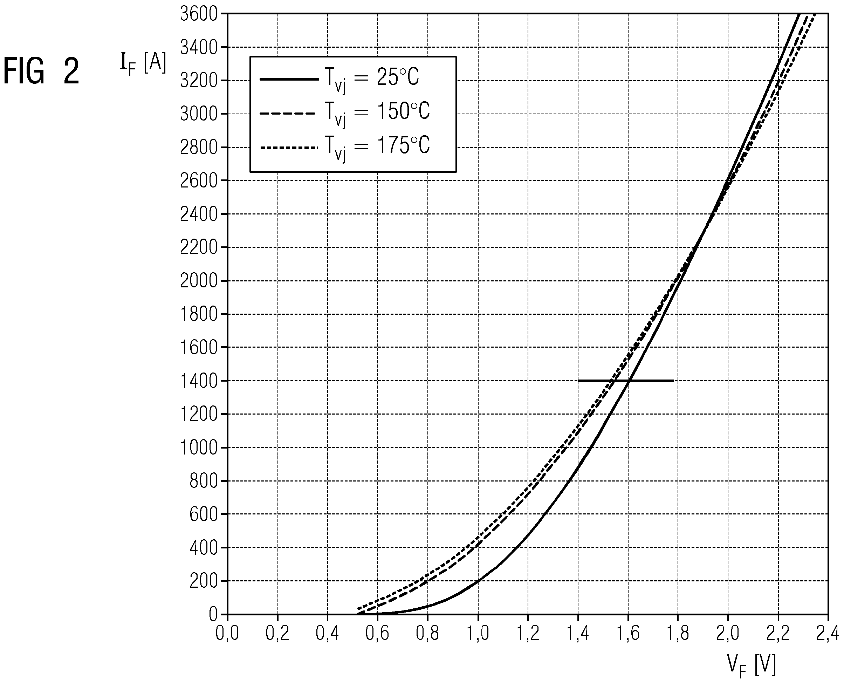

Die FIG 2 zeigt die thermische Abhängigkeit eines Halbleiters am Beispiel einer im Halbleiter angeordneten Diode. Dargestellt ist die Durchlasskennlinie der Diode für verschiedene Temperaturen des Halbleiters. Am Beispiel für einen gekennzeichneten Strom von 1400 A ist erkennbar, dass die Durchlassspannung mit steigender Temperatur sinkt. Das bedeutet, dass bei einer Parallelschaltung zweier oder noch mehr dieser Halbleiter, der wärmste Halbleiter aufgrund der geringeren Durchlassspannung noch mehr Strom übernimmt, wenn keine Maßnahmen getroffen werden. Dadurch erhöht sich die Temperatur noch weiter und die Temperaturen der parallelen Halbleiter laufen immer weiter auseinander. Die vorgeschlagene Anordnung kann dieses Auseinanderlaufen zuverlässig verhindern. Dieses Verhalten, dass sich die Durchlassspannung bei steigender Temperatur und konstantem Strom verringert, wird auch als positive Strom-Temperaturabhängigkeit bezeichnet. Insbesondere Halbleitern auf der Basis von Galliumnitrit und Siliziumcarbid weisen diese Eigenschaft auf.

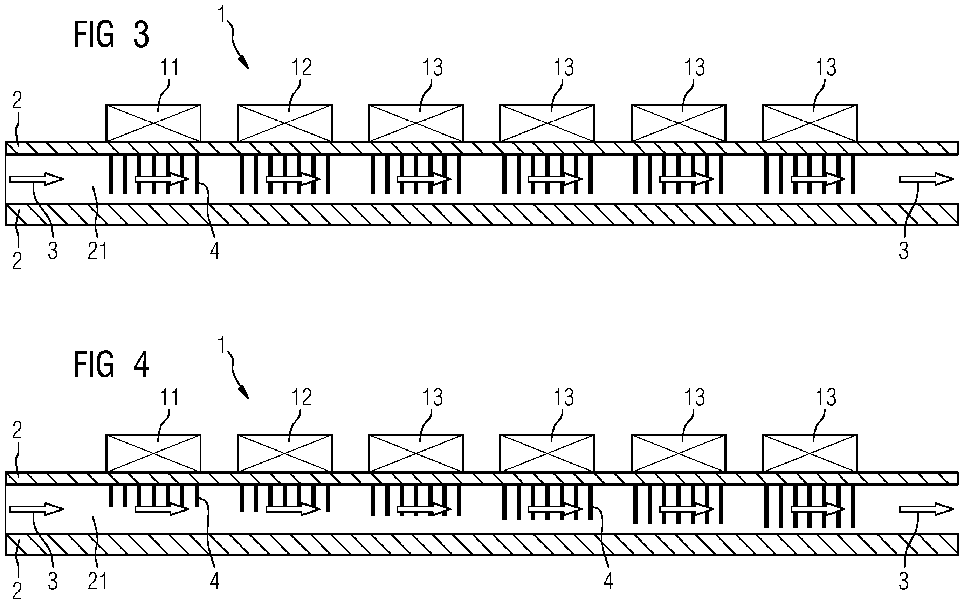

Die FIG 3 zeigt eine bekannte Anordnung bei der sechs Halbleiter 11, 12, 13 an einem Kühlkörper 2 angeordnet sind. Durch den Kühlkörper 2 wird die Wärme, überwiegend entstanden aus der Verlustleistung, der Halbleiter 11, 12, 13 über Kühlrippen 4 an das Kühlmedium 3 übertragen, dass symbolisch durch Pfeile gekennzeichnet ist. Der Kühlkörper 2 kann dabei, insbesondere bei einer Flüssigkeitskühlung, geschlossen ausgebildet sein und einen Kühlkanal 21 aufweisen. Bei einer Luftkühlung hingegen bedarf es keines Kühlkanals 21 so dass der Kühlkörper 2 an den Kühlrippen enden kann und keinen Kühlkanal 21 aufzuweisen braucht.

Der Kühlmittelstrom, unabhängig davon, ob es sich um ein flüssiges oder gasförmiges Kühlmedium 3 handelt, bewegt sich in der Darstellung von links nach rechts. Dabei nimmt es von jedem Halbleiter 11, 12, 13 Wärme auf und erwärmt sich dadurch. Aufgrund der geringeren Temperaturdifferenz verringert sich mit steigender Temperatur des Kühlmedium 3 auch die Aufnahmefähigkeit an Wärme. Das führt dazu, sich die weiteren Halbleiter 13 stärker erwärmen als der zweite Halbleiter 12. Der zweite Halbleiter 12 erwärmt sich stärker als der erste Halbleiter 11.

Die einfachste und günstigste Technologie bei einem flüssigkeitsgekühlten oder gasgekühltem Kühlkörper 2 ist, wie dargestellt, mit einem Kühlkanal 21, der sich gradlinig, in diesem Fall von links nach rechts erstreckt, realisiert. Um die Verlustenergie der sechs Halbleiter abzuleiten, fließt der Fluid oder das gasförmige Kühlmedium unter den sechs Halbleitern 11, 12, 13 von dem ersten bis zum sechsten. Um die Entwärmung der Halbleiter zu optimieren, ist der Kühlkanal 21 mit Kühlrippen 4 wie Pins/Fins gefüllt. Mit den Kühlrippen wird die Abgabe der Wärme vom Halbleiter 11, 12, 13 an das Kühlmedium 3 verbessert. Dabei steigt die Temperatur im Bereich jedes Halbleiter 11, 12, 13 durch die Aufnahme von Wärme an. Durch die höhere Temperatur verringert sich jedoch bei jedem weiteren Halbleiter 13 die abgegebene Wärmemenge, so dass sich auch die Temperaturen der weiteren Halbleiter 13 gegenüber dem ersten Halbleiter 11 und dem zweiten Halbleiter 12 erhöht. Ebenso steigt die Temperatur des zweiten Halbleiters 12 gegenüber der Temperatur des ersten Halbleiters 11, da das Kühlmedium 3 im Bereich des zweiten Halbleiters 12 durch die Aufnahme von Wärme des ersten Halbleiter 11 sich erhöht hat.

Mit Einführung der neusten Generation an IGBTs im Modul sind die oberen Grenzen der zulässigen Temperaturen, insbesondere der Chiptemperaturen oder der Sperrschichttemperaturen, und entsprechend auch die zulässige Verlustleistung gestiegen. So steigt beispielsweise bei 5 kW Verlustleistung und ca. 7 l/min an Kühlmitteldurchsatz einer Flüssigkeitskühlung pro Halbleiter 11, 12, 13 die Ablauftemperatur gegenüber der Zulauftemperatur beim Modul mit sechs Halbleitern um 12K. Das bedeutet, dass die mittlere Temperatur des Kühlmediums 3 unter dem Halbleiter 11, 12, 13 in der Kühlreihe zum nächsten Halbleiter sich um ca. 2K unterscheidet. Zwischen dem letzte weiteren Halbleiter 13 und dem ersten Halbleiter 11 weist das Kühlmittel 3 eine Temperaturdifferenz von 10K auf. Falls es sich um eine Parallelschaltung der Halbleiter 11, 12, 13 oder einer Teilmenge der Halbleiter 11, 12, 13 handelt und diese eine positive Strom-Temperaturabhängigkeit besitzen, so treibt dies die Temperaturen der einzelnen Halbleiter durch eine ungleiche Aufteilung der Ströme noch weiter auseinander. Das reduziert die Effektivität der Kühlung, weil ein entsprechendes Derating benötigt wird und die Auslegung auf den wärmsten Halbleiter, insbesondere auf die Diode des wärmsten Halbleiters, vorzunehmen ist. Die wärmste Diode liegt dabei im weiteren Halbleiter 13, der in der FIG 3 ganz rechts angeordnet ist und die Vorerwärmung der übrigen Halbleiter 11, 12, 13 erfährt.

Die FIG 4 zeigt ein Ausführungsbeispiel der vorgeschlagenen Halbleiteranordnung 1. Zur Vermeidung von Wiederholungen wird auf die Beschreibung zu den Figuren 1 bis 3, sowie auf die dort eingeführten Bezugszeichen verwiesen. Der thermische Widerstand zur Übertragung von Wärme vom Halbleiter 11, 12, 13 zum Kühlmedium unterscheidet sich für jeden Halbleiter 11, 12, 13. Dabei sinkt der thermische Widerstand, in der Darstellung der FIG 4 von links nach rechts. Mit anderen Worten liegt im Bereich des ersten Halbleiters 11 der größte thermische Widerstand vor. Im Bereich des zweiten Halbleiters 12 ist der thermische Widerstand Rₜₕ₂ geringer als der thermische Widerstand Rₜₕ₁ im Bereich des ersten Halbleiters 11. Bei den weiteren Halbleitern 13 verringert sich der thermische Widerstand weiter in Richtung des Kühlmittelstroms.

Dies wird dadurch erreicht, dass zur Erzielung eines geringeren thermischen Widerstands die Kühlrippen 4, also die Pins und/oder Fins länger ausgebildet sind. Je länger die Kühlrippen 4, desto geringer der thermische Widerstand in dem Bereich.

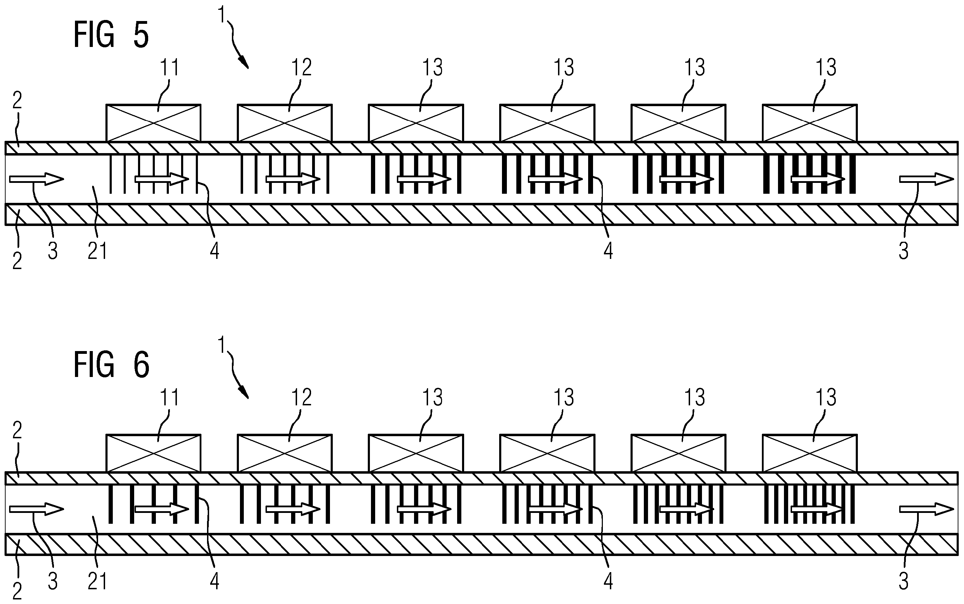

Die FIG 5 zeigt ein weiteres Ausführungsbeispiel der vorgeschlagenen Halbleiteranordnung 1. Zur Vermeidung von Wiederholungen wird auf die Beschreibung zu den Figuren 1 bis 4, sowie auf die dort eingeführten Bezugszeichen verwiesen. Zur Erzielung eines geringeren thermischen Widerstands Rₜₕ werden die Kühlrippen 4 dicker ausgebildet. Das erhöht nicht nur die Oberfläche der Kühlrippen 4 und verbessert allein schon dadurch die Wärmeübertragung, sondern durch die sich dadurch ergebende geringere Querschnittsfläche im Bereich des jeweiligen Halbleiters erhöht sich auch die Fließgeschwindigkeit des Kühlmittels 3 in dem Bereich. Das führt ebenfalls zu einer weiteren Verringerung des thermischen Widerstands Rₜₕ.

Die FIG 6 zeigt ein weiteres Ausführungsbeispiel der vorgeschlagenen Halbleiteranordnung 1. Zur Vermeidung von Wiederholungen wird auf die Beschreibung zu den Figuren 1 bis 5, sowie auf die dort eingeführten Bezugszeichen verwiesen. Zur Erzielung eines geringeren thermischen Widerstands Rₜₕ wird dabei die Anzahl der Kühlrippen 4 erhöht. Auch dies hat, wie im Ausführungsbeispiel der FIG 5, die Wirkung, dass sich sowohl die wirksame Oberfläche für die Wärmeübertragung erhöht als auch sich der Querschnitt des Kühlkanals 21 im Bereich mit zunehmender Vorerwärmung weiter verringert. Beides hat den technischen Effekt, den thermischen Widerstand Rₜₕ zu verringern.

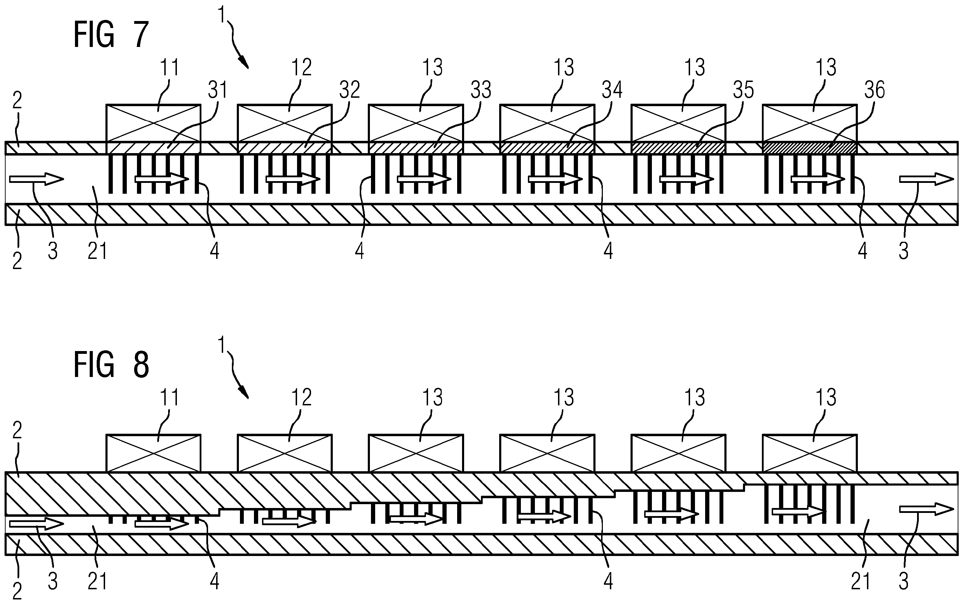

Die FIG 7 zeigt ein weiteres Ausführungsbeispiel der vorgeschlagenen Halbleiteranordnung 1. Zur Vermeidung von Wiederholungen wird auf die Beschreibung zu den Figuren 1 bis 6, sowie auf die dort eingeführten Bezugszeichen verwiesen. In diesem Ausführungsbeispiel wird zur Veränderung des thermischen Widerstands Rₜₕ unterschiedliche Materialien in den Bereichen der einzelnen Halbleiter 11, 12, 13 angeordnet. Dies ist durch die schraffierten Bereiche im betreffenden Bereich gekennzeichnet. So wird zur Erzielung eines hohen thermischen Widerstands in dem betreffenden Bereich des jeweiligen Halbleiters 11, 12, 13 ein Material mit geringer thermischer Leitfähigkeit angeordnet. So wird im ersten Bereich 31 ein erstes Material mit geringster thermischer Leitfähigkeit angeordnet. Im zweiten Bereich 32 weist das zweite Material einen geringeren thermischen Widerstand auf als das erste Material. Dies wir mit einer höheren thermischen Leitfähigkeit des zweiten Materials erreicht. Wiederum im dritten Bereich 33 weist das dritte Material einen geringeren thermischen Widerstand auf als das zweite Material. Dies wir mit einer höheren thermischen Leitfähigkeit des dritten Materials erreicht. Weiter weist im vierten Bereich 34 das vierte Material einen geringeren thermischen Widerstand auf als das dritte Material. Dies wir mit einer höheren thermischen Leitfähigkeit des vierten Materials erreicht. Analog weist im fünften Bereich 35 das fünfte Material einen geringeren thermischen Widerstand auf als das vierte Material. Dies wir mit einer höheren thermischen Leitfähigkeit des fünften Materials erreicht. Abschließend weist im sechsten Bereich 36 das sechste Material einen geringeren thermischen Widerstand auf als das fünfte Material. Dies wir mit einer höheren thermischen Leitfähigkeit des sechsten Materials erreicht. So kann mit voranschreitender Vorerwärmung die Kühlung durch die Verwendung unterschiedlicher thermischer Materialeigenschaften verbessert werden. Dadurch gleicht sich das Temperaturverhalten der einzelnen Halbleiter 11, 12, 13 trotz vorliegender Vorerwärmung für den zweiten Halbleiter 12 und die weiteren Halbleiter 13 deutlich an.

Die FIG 8 zeigt ein weiteres Ausführungsbeispiel der vorgeschlagenen Halbleiteranordnung 1. Zur Vermeidung von Wiederholungen wird auf die Beschreibung zu den Figuren 1 bis 7, sowie auf die dort eingeführten Bezugszeichen verwiesen. Der thermische Widerstand ergibt sich aus der Dicke der Schicht im Kühlkörper 2 zwischen dem jeweiligen Halbleiter 11, 12, 13 und dem Kühlmedium. Zur Erzielung des größten thermischen Widerstands ist diese Schicht am dicksten. Die Dicke nimmt dabei von Halbleiter zu Halbleiter in Richtung des Kühlmittelflusses, also in Richtung fortschreitender Vorerwärmung, ab. Dies kann beispielsweise kontinuierlich, mit Rampen oder auch stufenförmig geschehen. Mit abnehmender Schichtdicke des Kühlkörpers im Bereich des jeweiligen Kühlkörpers sinkt auch der thermische Widerstand Rₜₕ.

Die in den Ausführungsbeispielen genannten Maßnahmen zur Veränderung, insbesondere zur Erhöhung oder Reduzierung, des thermischen Widerstandes Rₜₕ können für sich alleine zur Anwendung kommen oder beliebig miteinander kombiniert werden. So ist zum Beispiel die Verwendung unterschiedlicher Materialien mit unterschiedlichen thermischen Eigenschaften auch mit den anderen genannten Ausführungen kombinierbar.

Zusammenfassend betrifft die Erfindung eine Halbleiteranordnung mit einem ersten Halbleiter und einem zweiten Halbleiter, einem Kühlkörper zum Übertragen von Verlustwärme des ersten Halbleiters und des zweiten Halbleiters an ein Kühlmedium, wobei der erste Halbleiter und der zweite Halbleiter derart an dem Kühlkörper angeordnet sind, dass von dem zweiten Halbleiter Verlustwärme an das von dem ersten Halbleiter vorerwärmte Kühlmedium übertragbar ist. Zur Verbesserung der Halbleiteranordnung wird vorgeschlagen, dass ein erster thermischer Widerstand für den Wärmeübergang von dem ersten Halbleiter zu dem Kühlmedium größer ist als ein zweiter thermischer Widerstand für den Wärmeübergang von dem zweiten Halbleiter zu dem Kühlmedium. Ferner betrifft die Erfindung einen Stromrichter mit mindestens einer derartigen Halbleiteranordnung. Die Erfindung betrifft weiter ein Verfahren zum Betreiben einer derartigen Halbleiteranordnung oder eines derartigen Stromrichters, wobei in Abhängigkeit von der Temperatur des Kühlmediums und/oder eines der Halbleiter die Fließgeschwindigkeit des Kühlmediums verändert wird.

## Patentansprüche

1. Halbleiteranordnung (1) aufweisend
- einen ersten Halbleiter (11) und einen zweiten Halbleiter (12),
- einen Kühlkörper (2) zum Übertragen von Verlustwärme des ersten Halbleiters (11) und des zweiten Halbleiters (12) an ein Kühlmedium (3), wobei der erste Halbleiter (11) und der zweite Halbleiter (12) derart an dem Kühlkörper (2) angeordnet sind, dass von dem zweiten Halbleiter (12) Verlustwärme an das von dem ersten Halbleiter (11) vorerwärmte Kühlmedium (3) übertragbar ist,
**dadurch gekennzeichnet, dass** ein erster thermischer Widerstand (Rₜₕ₁) für den Wärmeübergang von dem ersten Halbleiter (11) zu dem Kühlmedium (3) größer ist als ein zweiter thermischer Widerstand (Rₜₕ₂) für den Wärmeübergang von dem zweiten Halbleiter (12) zu dem Kühlmedium (3) .

2. Halbleiteranordnung (1) nach Anspruch 1, wobei die Halbleiteranordnung (1) mindestens einen weiteren Halbleiter (13) aufweist, wobei der weitere Halbleiter (13) derart angeordnet ist, dass von dem weiteren Halbleiter (13) Verlustwärme an das von dem ersten und dem zweiten Halbleiter (11,12) vorerwärmte Kühlmedium (3) übertragbar ist, wobei ein dritter thermischer Widerstand (Rₜₕ₃) für den Wärmeübergang von dem weiteren Halbleiter (13) zu dem Kühlmedium (3) jeweils kleiner ist als der erste thermische Widerstand (Rₜₕ₁) und als der zweite thermische Widerstand (Rₜₕ₂).

3. Halbleiteranordnung (1) nach einem der Ansprüche 1 oder 2, wobei die Halbleiteranordnung (1) eine Vielzahl von Halbleitern (11,12,13), insbesondere genau sechs Halbleiter (11,12, 13), aufweist, wobei die Halbleiter (11,12,13) thermisch in Reihe angeordnet sind, wobei der thermische Widerstand (Rₜₕₓ) zwischen einem der Halbleiter (11,12,13) und dem Kühlmedium (3) in Positionen mit zunehmender Vorerwärmung durch den bzw. die thermisch vorgelagerten Halbleiter (11,12,13) sinkt.

4. Halbleiteranordnung (1) nach einem der Ansprüche 1 bis 3, wobei die Halbleiter (11,12,13) eine für den Betrieb zulässige Sperrschichttemperatur von mindestens 150°C aufweisen.

5. Halbleiteranordnung (1) nach einem der Ansprüche 1 bis 4, wobei die Halbleiter (11,12,13) in ihrem thermischen Verhalten eine positive Strom-Temperaturabhängigkeit aufweisen.

6. Halbleiteranordnung (1) nach einem der Ansprüche 1 bis 5, wobei die Halbleiter (11,12,13) Galliumnitrit oder Siliziumcarbid aufweisen.

7. Halbleiteranordnung (1) nach einem der Ansprüche 1 bis 6, wobei mindestens zwei der Halbleiter (11,12,13) elektrisch parallel angeordnet sind.

8. Halbleiteranordnung (1) nach einem der Ansprüche 1 bis 7, wobei der Kühlkörper (2) als flüssigkeitsgekühlter Kühlkörper mit einem Kühlkanal (21) ausgebildet ist.

9. Halbleiteranordnung (1) nach Anspruch 8, wobei der Kühlkanal (21) zumindest in Teilen des für den Wärmeübergang relevanten Bereichs des ersten Halbleiters (11) eine größere Querschnittsfläche aufweist im Vergleich zu der Querschnittsfläche im entsprechenden Bereich des zweiten Halbleiters (12) .

10. Halbleiteranordnung (1) nach einem der Ansprüche 1 bis 9, wobei der Kühlkörper (2) in einem ersten Bereich (31) des ersten Halbleiters (11) ein erstes Material mit einer geringeren thermischen Leitfähigkeit aufweist als ein zweites Material im entsprechenden zweiten Bereich (32) des zweiten Halbleiters (12).

11. Halbleiteranordnung (1) nach einem der Ansprüche 1 bis 10, wobei der Kühlkörper (2) im Bereich des ersten Halbleiters (11) eine größere Materialstärke, insbesondere zwischen dem betreffenden Halbleiter (11,12,13) und dem Kühlkanal (21), im Vergleich zum entsprechenden Bereich des zweiten Halbleiters (12) aufweist.

12. Stromrichter (30) mit mindestens einer Halbleiteranordnung (1) nach einem der Ansprüche 1 bis 11.

13. Verfahren zum Betreiben einer Halbleiteranordnung (1) nach einem der Ansprüche 1 bis 11 oder eines Stromrichters (30) nach Anspruch 12, wobei in Abhängigkeit von der Temperatur des Kühlmediums (3) und/oder eines der Halbleiter (11,12,13) die Fließgeschwindigkeit des Kühlmediums (3) verändert wird.
